(19) **Europäisches Patentamt / European Patent Office / Office européen des brevets**

(11) **EP 4 113 132 B1**

(12) **FASCICULE DE BREVET EUROPEEN**

(45) Date de publication et mention de la délivrance du brevet:
**09.08.2023  Bulletin 2023/32**

(21) Numéro de dépôt: **22181113.6**

(22) Date de dépôt: **24.06.2022**

(51) Classification Internationale des Brevets (IPC):
**G01R 22/06** *(2006.01)*    *G01R 11/24* *(2006.01)*

(52) Classification Coopérative des Brevets (CPC):
**G01R 22/066; G01R 11/24**

(54) **ESTIMATION, MALGRE UNE FRAUDE, DE LA PUISSANCE CONSOMMEE SUR UNE PHASE**

SCHÄTZUNG DER AUF EINER PHASE VERBRAUCHTEN LEISTUNG TROTZ EINES BETRUGS

ESTIMATION, DESPITE FRAUD, OF THE POWER CONSUMED OVER A PHASE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.06.2021  FR 2107011**

(43) Date de publication de la demande:
**04.01.2023  Bulletin 2023/01**

(73) Titulaire: **Sagemcom Energy & Telecom SAS 92500 Rueil-Malmaison (FR)**

(72) Inventeurs:
- **TEBOULLE, Henri**
  **92500 RUEIL MALMAISON (FR)**
- **NOIRET, Sébastien**
  **92500 RUEIL MALMAISON (FR)**

(74) Mandataire: **Lavaud, Thomas**
  **Cabinet Boettcher**
  **5, rue de Vienne**
  **75008 Paris (FR)**

(56) Documents cités:
EP-A2- 0 455 518       US-A1- 2004 150 384
US-A1- 2013 211 751    US-B1- 6 236 197

**Description**

L'invention concerne le domaine des compteurs électriques triphasés.

ARRIERE PLAN DE L'INVENTION

Les compteurs électriques, utilisés dans les applications industrielles, mesurent fréquemment des puissances et des énergies électriques qui sont distribuées via des niveaux de courant très élevés (jusqu'à 2000A typiquement). Ces compteurs sont généralement des compteurs triphasés.

Un tel compteur comporte des entrées de courant et des entrées de tension.

Des capteurs de courant, par exemple des capteurs de Rogowski ou des transformateurs de courant externes, sont classiquement montés sur les phases. Chaque capteur de courant est relié à une entrée de courant par deux fils conducteurs. Le compteur acquiert ainsi, pour chaque phase, une image du courant circulant sur ladite phase.

Chaque entrée de tension est classiquement reliée à une phase par un fil conducteur. Le compteur accède ainsi directement à la tension présente sur chaque phase via le fil conducteur associé.

Une fraude connue consiste à couper un ou des fils conducteurs qui relient les phases aux entrées de tension. Le but d'une telle fraude est de faire sous-évaluer l'énergie totale consommée qui est mesurée par le compteur, de manière à réduire la facture à payer au distributeur d'énergie électrique.

En cas de fraude, les compteurs de l'art antérieur continuent de réaliser les mesures métrologiques en l'état sur les trois phases, sans tenir compte de la fraude, et donc sous-évaluent effectivement l'énergie consommée. Même si la fraude est détectée, le distributeur ne connaît pas l'énergie réellement consommée par l'installation du fraudeur. Or, il peut s'avérer utile de connaître l'énergie réellement consommée, par exemple pour réclamer au fraudeur le paiement de l'énergie non facturée (en plus d'éventuelles pénalités visant à sanctionner la tentative de fraude).

EP 0 455 518 A2 divulgue un méthode d'estimation de la puissance consommée sur une phase , malgré une fraude, ou l'énergie consommée est estimée à partir d'une estimation du voltage sur la phase faussée et le curent mesurée sur cette phase.

US 2013/211751 A1 divulgue un méthode d'estimation d'une voltage basée sur la mesure d'une deuxième voltage.

US 6 236 197 B1 et US 2004/150384 A1 divulguent un méthode de détermination de fraude sur uns système triphasée.

OBJET DE L'INVENTION

L'invention a pour objet d'estimer, malgré une fraude consistant à fausser des mesures de tension sur une phase, l'énergie totale consommée par une installation.

RESUME DE L'INVENTION

En vue de la réalisation de ce but, on propose un procédé d'estimation de puissance, mis en oeuvre dans un compteur électrique triphasé relié à trois phases d'un réseau de distribution, et comprenant les étapes de :

- détecter une fraude faussant au moins une première mesure de tension, image d'une première tension de phase présente sur une première phase ;
- acquérir au moins une deuxième mesure de tension, image d'une deuxième tension de phase présente sur une deuxième phase, la au moins une deuxième mesure de tension n'étant pas faussée par la fraude ;
- estimer un premier déphasage entre la première tension de phase et un premier courant de phase circulant sur la première phase, en utilisant une première estimation de déphasage qui est une estimation théorique d'un déphasage attendu sans la fraude entre la première tension de phase et la deuxième tension de phase ;
- estimer au moins une première puissance électrique consommée sur la première phase à partir d'au moins une première mesure de courant image du premier courant de phase, de la au moins une deuxième mesure de tension, et du premier déphasage.

Lorsqu'une fraude est détectée sur la première phase, les premières mesures de tension sont faussées et ne sont donc pas utilisables.

Le procédé d'estimation de puissance selon l'invention utilise alors notamment les deuxièmes mesures de tension sur la deuxième phase, ainsi qu'une estimation théorique du premier déphasage entre la première tension de phase et le premier courant de phase, pour estimer les premières puissances électriques.

Le distributeur d'énergie peut donc obtenir, malgré la fraude, une estimation relativement précise des puissances électriques totales et de l'énergie totale réellement consommées par l'installation.

On propose de plus un procédé d'estimation de puissance tel que précédemment décrit, dans lequel le premier déphasage est estimé à partir d'un déphasage entre la deuxième tension de phase et un deuxième courant de phase circulant sur la deuxième phase, d'une différence de phase entre le deuxième courant de phase et le premier courant de phase, et de la première estimation de déphasage.

On propose de plus un procédé d'estimation de puissance tel que précédemment décrit, dans lequel la première estimation de déphasage est égale à +120° ou à -120°.

On propose de plus un procédé d'estimation de puissance tel que précédemment décrit, dans lequel la au moins une deuxième mesure de tension comprend une valeur efficace de la deuxième tension de phase et/ou un niveau sur une fréquence fondamentale de la deuxième tension de phase.

On propose de plus un procédé d'estimation de puissance tel que précédemment décrit, dans lequel la au moins une première puissance électrique comprend une première Puissance Active estimée à partir de la valeur efficace de la deuxième tension de phase, d'une valeur efficace du premier courant de phase, et du premier déphasage, et/ou une première Puissance Réactive estimée à partir du niveau sur la fréquence fondamentale de la deuxième tension de phase, d'un niveau sur une fréquence fondamentale du premier courant de phase, et du premier déphasage, et/ou une première Puissance Apparente estimée à partir de la valeur efficace de la deuxième tension de phase et de la valeur efficace du premier courant de phase.

On propose de plus un procédé d'estimation de puissance tel que précédemment décrit, dans lequel la fraude est détectée lorsque la au moins une première mesure de tension est inférieure à un seuil de tension prédéfini alors que la au moins une première mesure de courant est supérieure à un seuil de courant prédéfini.

On propose de plus un procédé d'estimation de puissance tel que précédemment décrit, comprenant en outre les étapes, si la fraude fausse aussi au moins une troisième mesure de tension, image d'une troisième tension de phase présente sur une troisième phase, d'utiliser à nouveau la au moins une deuxième mesure de tension pour estimer au moins une troisième puissance électrique consommée sur la troisième phase.

On propose de plus un procédé d'estimation de puissance tel que précédemment décrit, comprenant en outre les étapes de :

- acquérir au moins une troisième mesure de tension, image d'une troisième tension de phase présente sur une troisième phase, la troisième mesure de tension n'étant pas faussée par la fraude ;
- calculer une moyenne arithmétique de la au moins une deuxième mesure de tension et de la au moins une troisième mesure de tension pour estimer la au moins une première puissance électrique.

On propose de plus un procédé d'estimation de puissance tel que précédemment décrit, dans lequel le premier déphasage est obtenu en calculant une moyenne arithmétique d'un déphasage obtenu en utilisant des mesures sur la deuxième phase et d'un déphasage obtenu en utilisant des mesures sur la troisième phase.

On propose de plus un procédé d'estimation de puissance tel que précédemment décrit, comprenant en outre les étapes de détecter si le réseau de distribution comprend ou non un neutre en plus des trois phases et, si ce n'est pas le cas, de corriger au moins une deuxième puissance électrique consommée sur la deuxième phase, et, si la fraude ne fausse pas au moins une troisième mesure de tension, image d'une troisième tension de phase présente sur une troisième phase, de corriger aussi au moins une troisième puissance électrique consommée sur la troisième phase.

On propose de plus un procédé d'estimation de puissance tel que précédemment décrit, dans lequel la correction consiste à multiplier la au moins une deuxième puissance électrique et la au moins une troisième puissance électrique par un même facteur prédéterminé, et à déphaser la au moins une deuxième puissance électrique d'un deuxième déphasage prédéfini, et la au moins une troisième puissance électrique d'un troisième déphasage prédéfini.

On propose de plus un procédé d'estimation de puissance tel que précédemment décrit, dans lequel le facteur prédéterminé est égal à $\frac{2}{\sqrt{3}}$, et dans lequel le deuxième déphasage prédéfini est égal à -30° et le troisième déphasage prédéfini est égal à +30°.

On propose de plus un procédé d'estimation de puissance tel que précédemment décrit, dans lequel une absence de neutre est détectée lorsqu'un angle φ entre la deuxième tension de phase et la troisième tension de phase est tel que :

$$180° - X° < |\varphi| < 180° + X°,$$

X étant une valeur prédéfinie positive et inférieure à 30.

On propose de plus un compteur électrique triphasé, comprenant un composant de traitement agencé pour mettre en oeuvre le procédé d'estimation de puissance tel que précédemment décrit.

On propose de plus un compteur électrique triphasé tel que précédemment décrit, comprenant en outre un composant de mesure, distinct du composant de traitement et agencé pour produire la au moins une première mesure de tension, la au moins une deuxième mesure de tension et la au moins une première mesure de courant.

On propose de plus un programme d'ordinateur comprenant des instructions qui conduisent le composant de traitement du compteur électrique triphasé tel que précédemment décrit à exécuter les étapes du procédé d'estimation de puissance tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en oeuvre particulier non limitatif de l'invention.

BREVE DESCRIPTION DES DESSINS

Il sera fait référence aux dessins annexés parmi lesquels :

[Fig. 1] la figure 1 représente un compteur électrique triphasé selon l'invention, dans une configuration à quatre fils ;
[Fig. 2] la figure 2 représente un compteur électrique triphasé selon l'invention, dans une configuration à trois fils ;
[Fig. 3] la figure 3 représente, dans la configuration à quatre fils, les diagrammes de Fresnel des tensions et des courants mesurés sur les phases dans le cas normal (à gauche), et en cas de fraude (à droite) ;
[Fig. 4] la figure 4 est une figure similaire à la figure 3, mais dans une configuration à trois fils ;
[Fig. 5] la figure 5 est un organigramme représentant les étapes du procédé d'estimation de puissance selon l'invention.

DESCRIPTION DETAILLEE DE L'INVENTION

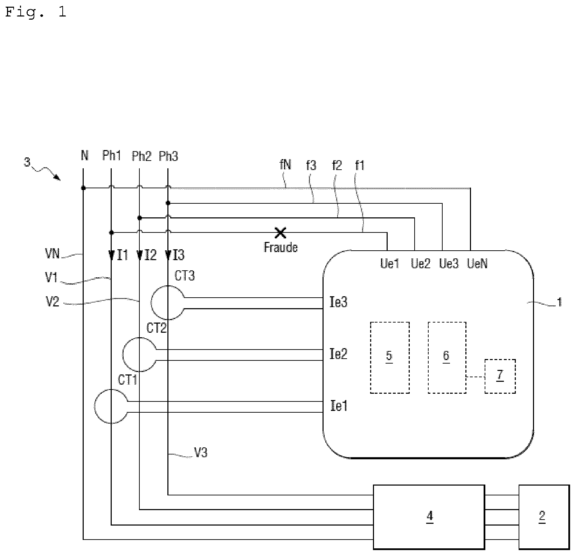

En référence à la figure 1, le procédé d'estimation de puissance selon l'invention est mis en oeuvre dans un compteur électrique triphasé 1 qui est destiné à mesurer l'énergie électrique fournie à l'installation 2 d'un abonné par un réseau de distribution 3. Cette installation 2 est une installation industrielle.

On se place ici dans une configuration à quatre fils.

Le réseau de distribution 3 comprend donc une première phase Ph1, une deuxième phase Ph2, une troisième phase Ph3 et un neutre N. Un disjoncteur 4 est positionné « à la frontière » entre le réseau de distribution 3 et l'installation 2. Les trois phases Ph1, Ph2, Ph3 et le neutre N rentrent dans le disjoncteur 4 et en ressortent vers l'installation 2. Le disjoncteur 4 permet de couper la distribution d'énergie électrique.

Le compteur 1 comprend quatre entrées de tension Ue1, Ue2, Ue3, UeN et trois entrées de courant Ie1, Ie2, Ie3 (chaque entrée de courant comprenant deux ports).

L'entrée de tension Ue1 est reliée à la première phase Ph1 par un fil conducteur f1, l'entrée de tension Ue2 est reliée à la deuxième phase Ph2 par un fil conducteur f2, l'entrée de tension Ue3 est reliée à la troisième phase Ph3 par un fil conducteur f3 et l'entrée de tension UeN est reliée au neutre N par un fil conducteur fN.

L'entrée de courant Ie1 est reliée à un transformateur de courant externe CT1 monté sur la première phase Ph1, l'entrée de courant Ie2 est reliée à un transformateur de courant externe CT2 monté sur la deuxième phase Ph2, et l'entrée de courant Ie3 est reliée à un transformateur de courant externe CT3 monté sur la troisième phase Ph3. Les transformateurs de courant externes sont situés à l'extérieur du compteur 1.

Chaque transformateur de courant externe présente ici un rapport de transformation égal à 2000.

Pour réaliser les mesures métrologiques, le compteur 1 récupère, au niveau des entrées de courant Ie1, Ie2, Ie3, et grâce aux transformateurs externes CT1, CT2 et CT3, une image des courants de phase I1, I2, I3 circulant sur les phases Ph1, Ph2 et Ph3. Le compteur 1 récupère aussi, sur les entrées de tension Ue1, Ue2, Ue3 et UeN, les tensions de phase V1, V2, V3 présentes sur les phases Ph1, Ph2, Ph3 et la tension de neutre VN présente sur le neutre N.

Le compteur 1 comporte de plus un coeur métrologique qui est un composant de mesure 5 « tout intégré ». Le composant de mesure 5 comprend des entrées reliées au entrées de courant Ie1, Ie2, Ie3 et aux entrées de tension Ue1, Ue2, Ue3, UeN, et intègre notamment des filtres d'entrée, des convertisseurs analogiques numériques, un module de calcul numérique, et un module de communication numérique pour transmettre les mesures numériques qu'il réalise.

Le composant de mesure 5 produit des premières mesures de tension, images de la première tension de phase V1 présente sur la première phase Ph1, et des premières mesures de courant, images du premier courant de phase I1 circulant sur la première phase Ph1. En particulier, le composant de mesure 5 produit les mesures suivantes (après calculs) :

$V1_{RMS}$, qui est la valeur efficace de la première tension de phase V1 ;

$VF1_{RMS}$, qui est le niveau sur la fréquence fondamentale de la première tension de phase V1 ;

$I1_{RMS}$, qui est la valeur efficace du premier courant de phase I1 ;

$IF1_{RMS}$, qui est le niveau sur la fréquence fondamentale du premier courant de phase I1.

De même, le composant de mesure 5 produit, pour la deuxième phase Ph2, des deuxièmes mesures de tension et des deuxièmes mesures de courant. En particulier, le composant de mesure 5 produit les mesures suivantes (après calculs) :

$V2_{RMS}$, $VF2_{RMS}$, $I2_{RMS}$, $IF2_{RMS}$.

De même, le composant de mesure 5 produit, pour la troisième phase Ph3, des troisièmes mesures de tension et des troisièmes mesures de courant. En particulier, le composant de mesure 5 produit les mesures suivantes (après calculs) :

$V3_{RMS}$, $VF3_{RMS}$, $I3_{RMS}$, $IF3_{RMS}$.

Le composant de mesure 5 produit aussi, pour chaque phase, des mesures du déphasage entre la tension de phase et le courant de phase sur ladite phase. Le composant de mesure 5 produit aussi des mesures de différence de phase entre les tensions de phase de deux phases différentes et entre les courants de phase de deux phases différentes.

De plus, le composant de mesure 5 calcule, à partir de ces mesures, et pour chaque phase, la Puissance Active, la Puissance Réactive et la Puissance Apparente consommée sur ladite phase. Les mesures d'énergies consommées en fonction du temps découlent de ces estimations de puissance.

Le compteur 1 comporte de plus un composant de traitement 6.

Le composant de traitement 6 est adapté à exécuter des instructions d'un programme pour mettre en oeuvre le procédé d'estimation de puissance selon l'invention. Le programme est stocké dans une mémoire 7, qui est intégrée dans ou reliée au composant de traitement 6. Le composant de traitement 6 est par exemple un processeur classique, un microcontrôleur, un DSP (pour *Digital Signal Processor,* que l'on peut traduire par « processeur de signal numérique »), ou bien un circuit logique programmable tel qu'un FPGA (pour *Field Programmable Gate Arrays*) ou un ASIC (pour *Application Spécifie Integrated Circuit*).

Ici, le composant de traitement 6 est un microcontrôleur.

Le microcontrôleur 6 est relié au composant de mesure 5 et acquiert les mesures (ainsi que les résultats de calcul et estimations) produites par le composant de mesure 5.

On note que le composant de mesure 5 fonctionne comme une « boîte noire » : le microcontrôleur 6 n'a accès qu'aux données produites en sortie par le composant de mesure 5 et pas aux données intermédiaires traitées dans le composant de mesure 5. Par ailleurs, les seules mesures auxquelles a accès le microcontrôleur 6 sont celles produites par le composant de mesure 5.

A intervalles réguliers, le microcontrôleur 6 tente de détecter la coupure frauduleuse de l'un des fils conducteurs f1, f2, f3. Le microcontrôleur 6 détecte une coupure du fil conducteur d'une phase en l'absence de tension et en la présence de courant sur ladite phase.

Pour la première phase Ph1, par exemple, le microcontrôleur 6 acquiert au moins une première mesure de tension et au moins une première mesure de courant produites par le composant de mesure 5, et détecte une fraude lorsque la au moins une première mesure de tension est inférieure à un seuil de tension prédéfini alors que la au moins une première mesure de courant est supérieure à un seuil de courant prédéfini.

Le microcontrôleur 6 détecte ici une fraude sur la première phase Ph1 lorsque :

$$V1_{RMS} < Vf$$

et

$$I1_{RMS} > If,$$

*Vf* étant le seuil de tension prédéfini et *If* étant le seuil de courant prédéfini.

Avantageusement, If est choisi de sorte que :

$$Istart < If < Imin,$$

*Istart* étant la valeur de courant à partir de laquelle le compteur 1 commence à mesurer l'énergie consommée, et *Imin* étant la valeur de courant à partir de laquelle le compteur 1 doit mesurer le courant avec la précision nominale.

Ici, on a *Istart* = 1mA et *Imin* = 10mA.

On choisit donc par exemple *If* = 5mA.

On choisit par exemple *Vf* = 40V.

Cette étape de détection de fraude est réalisée de la même manière pour les deux autres phases.

On suppose maintenant que le microcontrôleur 6 a détecté une fraude sur la première phase Ph1 (uniquement).

Les premières mesures de tension sont donc faussées par la fraude. Le microcontrôleur 6 va donc estimer au moins une première puissance électrique consommée sur la première phase Ph1 en utilisant les mesures de tension sur une phase de référence qui ne subit pas la fraude. Cette phase de référence est par exemple la deuxième phase Ph2. Le microcontrôleur 6 acquiert donc au moins une deuxième mesure de tension, image d'une deuxième tension de phase V2 présente sur la deuxième phase Ph2, la au moins une deuxième mesure de tension n'étant pas faussée par la fraude.

Le microcontrôleur 6 acquiert ici :

$V2_{RMS}$, $VF2_{RMS}$.

Le microcontrôleur 6 doit de plus estimer un premier déphasage entre la première tension de phase V1 et le premier courant de phase I1 circulant sur la première phase Ph1.

Or, l'information de déphasage fournie pour la première phase Ph1 par le composant de mesure 5 n'est pas valable du fait de la fraude.

Le microcontrôleur 6 va donc estimer le premier déphasage en utilisant une première estimation de déphasage, qui est une estimation théorique d'un déphasage attendu sans la fraude (c'est-à-dire en conditions normales), entre la première tension de phase V1 (dont la mesure n'est pas utilisable en l'occurrence) et la deuxième tension de phase (de référence).

La première estimation de déphasage est ici égale à +120°.

Plus précisément, le premier déphasage est estimé à partir d'un déphasage entre la deuxième tension de phase V2 et le deuxième courant de phase I2 circulant sur la deuxième phase Ph2, d'une différence de phase entre le deuxième courant de phase I2 et le premier courant de phase I1, et de la première estimation de déphasage.

On appelle $\varphi1$ le premier déphasage (estimé par le microcontrôleur 6) entre la première tension de phase V1 et le premier courant de phase I1.

On a donc :

$$\varphi1 \ = \ Phase \ de \ (V1) \ - \ Phase \ de \ (I1)$$

Pour obtenir $\varphi1$, le microcontrôleur 6 calcule :

$$\varphi1 = (Phase \ de \ V1 - Phase \ de \ V2) + (Phase \ de \ V2 - Phase \ de \ I2)$$
$$+ (Phase \ de \ I2 - Phase \ de \ I1)$$

Le microcontrôleur 6 assimile :

$$(Phase \ de \ V1 - Phase \ de \ V2)$$

à la première estimation de déphasage, c'est-à-dire à +120°.

La valeur :

$$(Phase \ de \ V2 - Phase \ de \ I2)$$

est mesurée par le composant de mesure 5 (et acquise par le microcontrôleur 6).

La valeur :

$$(Phase \ de \ I2 - Phase \ de \ I1)$$

est mesurée par le composant de mesure 5 (et acquise par le microcontrôleur 6).

Le premier déphasage $\varphi1$ est donc estimé de manière particulièrement astucieuse, sans utiliser les mesures sur la première phase Ph1 mais en utilisant les mesures disponibles non faussées ainsi que la première estimation de déphasage.

Le microcontrôleur 6 acquiert aussi au moins une première mesure de courant image du premier courant de phase I1 circulant sur la première phase Ph1 (la mesure de courant n'est pas faussée, car la fraude n'impacte que les premières mesures de tension).

Le microcontrôleur 6 estime alors au moins une première puissance électrique consommée sur la première phase Ph1 à partir d'au moins une première mesure de courant image du premier courant de phase I1, de la au moins une deuxième mesure de tension, et du premier déphasage.

Le microcontrôleur 6 calcule en l'occurrence la première Puissance Active, la première Puissance Réactive et la première Puissance Apparente consommées sur la première phase Ph1.

La première Puissance Active est estimée à partir de la valeur efficace de la deuxième tension de phase V2, d'une valeur efficace du premier courant de phase I1, et du premier déphasage. La première Puissance Réactive est estimée à partir du niveau sur la fréquence fondamentale de la deuxième tension de phase V2, du niveau sur la fréquence fondamentale du premier courant de phase I1, et du premier déphasage. La première Puissance Apparente est estimée à partir de la valeur efficace de la deuxième tension de phase V2 et de la valeur efficace du premier courant de phase I1.

Le microcontrôleur 6 calcule donc :

$$P_1 = V2_{RMS} \, . \, I1_{RMS}. \cos \varphi 1$$

(première Puissance Active) ;

$$Q_1 = VF2_{RMS} \, . \, IF1_{RMS}. \sin \varphi 1$$

(première Puissance Réactive) ;

$$S_1 = V2_{RMS} \, . \, I1_{RMS}$$

(première Puissance Apparente).

Si le microcontrôleur 6 détecte une fraude qui fausse au moins une première mesure de tension, image d'une première tension de phase V1 présente sur la première phase Ph1, et qui fausse aussi au moins une troisième mesure de tension, image d'une troisième tension de phase V3 présente sur la troisième phase Ph3, le microcontrôleur 6 utilise à nouveau la deuxième phase Ph2 comme phase de référence, à la fois pour estimer la ou les premières puissances électriques consommées sur la première phase Ph1, et la ou les troisièmes puissances électriques consommées sur la troisième phase Ph3.

Le microcontrôleur 6 calcule donc (comme précédemment décrit) :

$$P_1 = V2_{RMS} \, . \, I1_{RMS}. \cos \varphi 1$$

(première Puissance Active) ;

$$Q_1 = VF2_{RMS} \, . \, IF1_{RMS}. \sin \varphi 1$$

(première Puissance Réactive) ;

$$S_1 = V2_{RMS} \, . \, I1_{RMS}$$

(première Puissance Apparente).

Le microcontrôleur 6 estime aussi la troisième Puissance Active, la troisième Puissance Réactive et la troisième Puissance Apparente consommées sur la troisième phase, en calculant :

$$P_3 = V2_{RMS}. I3_{RMS}. \cos \varphi 3$$

(troisième Puissance Active) ;

$$Q_3 = VF2_{RMS}.IF3_{RMS}.\sin\varphi3$$

(troisième Puissance Réactive) ;

$$S_3 = V2_{RMS}.I3_{RMS}$$

(troisième Puissance Apparente).

Le troisième déphasage $\varphi3$ est tel que :

$$\varphi3 = Phase\ de\ (V3) - Phase\ de\ (I3)$$

Pour estimer le troisième déphasage <p3, le microcontrôleur 6 calcule :

$$\varphi3 = (Phase\ de\ V3 - Phase\ de\ V2) + (Phase\ de\ V2 - Phase\ de\ I2)$$
$$+ (Phase\ de\ I2 - Phase\ de\ I3)$$

Le microcontrôleur 6 assimile :

$$(Phase\ de\ V3 - Phase\ de\ V2)$$

à une troisième estimation de déphasage, ici égale à - 120°. La troisième estimation de déphasage est une estimation théorique d'un déphasage attendu sans la fraude (c'est-à-dire en conditions normales) entre la troisième tension de phase V3 (dont la mesure n'est pas utilisable en l'occurrence) et la deuxième tension de phase V2 (de référence).
La valeur :

$$(Phase\ de\ V2 - Phase\ de\ I2)$$

est mesurée par le composant de mesure 5.
La valeur :

$$(Phase\ de\ I2 - Phase\ de\ I3)$$

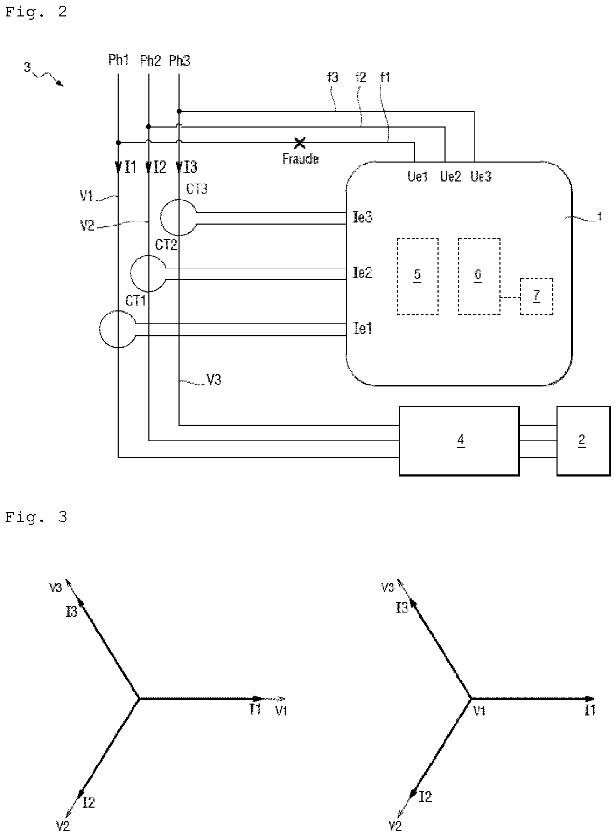

est mesurée par le composant de mesure 5.
En référence à la figure 2, on se place cette fois dans une configuration à trois fils.
Le réseau de distribution 3 comprend une première phase Ph1, une deuxième phase Ph2 et une troisième phase Ph3, mais pas de neutre.
Le compteur 1 comprend trois entrées de tension Ue1, Ue2, Ue3 et trois entrées de courant Ie1, Ie2, Ie3 (chaque entrée de courant comprenant deux ports).
Le compteur 1 comporte à nouveau un composant de mesure 5 et un microcontrôleur 6 relié au composant de mesure 5.
On se place à nouveau dans une situation où le fil conducteur f1 a été coupé par un utilisateur malintentionné.
On a donc :

$$V1_{RMS} < 40V$$

et

$$I1_{RMS} > 5mA.$$

Le microcontrôleur 6 a donc détecté une fraude qui fausse au moins une première mesure de tension, image d'une première tension de phase V1 présente sur la première phase Ph1.

On suppose que le microcontrôleur 6 n'a pas détecté de fraude sur la deuxième phase Ph2 ni sur la troisième phase Ph3. Les deuxièmes mesures de tension et les troisièmes mesures de tension ne sont donc pas faussées par la fraude qui touche la première phase Ph1.

La mise en oeuvre de l'invention est légèrement différente dans la configuration à trois fils.

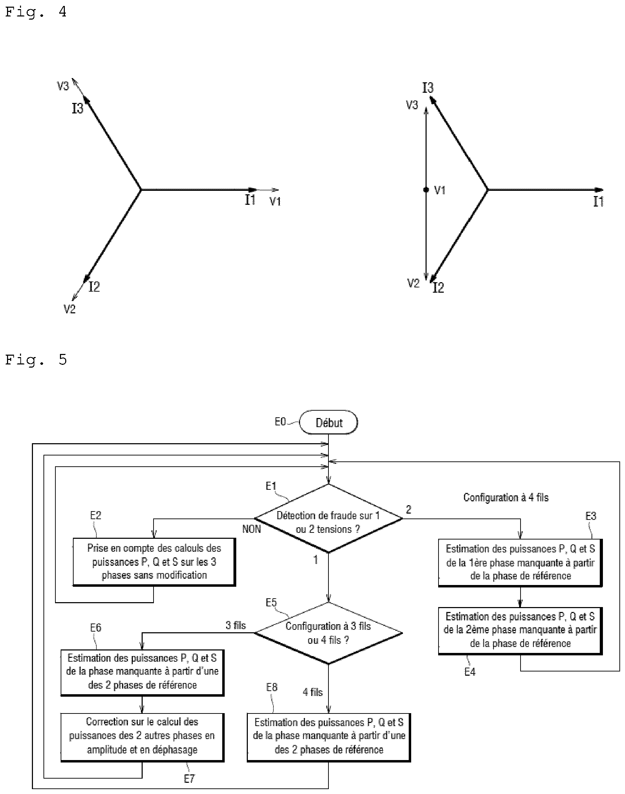

On explique la raison de cette différence à partir des schémas des figures 3 et 4.

La figure 3 représente, dans la configuration à quatre fils de la figure 1, le diagramme de Fresnel des tensions et des courants dans la cas normal (à gauche), et en cas de fraude consistant à couper le fil conducteur f1 (à droite).

On constate que l'absence d'une mesure de tension (mesure de V1 en l'occurrence) n'a aucun impact sur les amplitudes et les angles des autres tensions. En cas d'absence de deux tensions, il en est de même sur la tension restante.

La figure 4 représente, dans la configuration à trois fils de la figure 2, le diagramme de Fresnel des tensions et courants dans la cas normal (à gauche) et en cas de fraude consistant à couper le fil conducteur f1 (à droite).

On constate que l'absence d'une mesure de tension (mesure de V1 en l'occurrence) a un impact sur les amplitudes mesurées (qui sont diminuées d'un rapport $\cos(\pm 30°) = \frac{\sqrt{3}}{2})$ , mais aussi sur les angles mesurés des autres tensions (+30° sur la mesure de V2 et -30° sur la mesure de V3).

Le microcontrôleur 6 détecte donc tout d'abord, de manière préliminaire, si le réseau de distribution 3 comprend ou non un neutre en plus des trois phases.

Si ce n'est pas le cas, c'est-à-dire si la configuration est une configuration à trois fils, le microcontrôleur 6 tient compte du facteur $\frac{\sqrt{3}}{2}$ et des déphasages de +30° et -30° pour estimer les premières puissances électriques.

Comme on vient de le voir, l'angle de la mesure de V2 a augmenté de 30°.

Par conséquent, dans la configuration à trois fils, la première estimation de déphasage, égale à +120°, n'est plus égale à :

$$(Phase\ de\ V1 - Phase\ de\ V2),$$

mais à :

$$(Phase\ de\ V1 - (Phase\ de\ V2 - 30°))$$

En effet, la différence de phase de +120° correspond à une différence de phase entre la première tension de phase V1 et la deuxième tension de phase V2 lorsque la mesure de cette dernière n'a pas subi l'augmentation de +30° résultant de l'absence de la mesure de la première tension de phase V1 (dans la configuration à trois fils).

La valeur de phase *Phase de V2* - 30° correspond donc à la valeur de phase d'une deuxième mesure de tension virtuelle qui n'aurait pas été déphasée.

Le microcontrôleur 6 calcule donc tout d'abord

$$\varphi 1 = (Phase\ de\ V1 - (Phase\ de\ V2 - 30°)) + (Phase\ de\ V2 - Phase\ de\ I2) - 30°$$
$$+ (Phase\ de\ I2 - Phase\ de\ I1)$$

La valeur :

$$\varphi 2 = (Phase\ de\ V2 - Phase\ de\ I2)$$

est mesurée par le composant de mesure 5.

La valeur :

$$(Phase\ de\ I2 - Phase\ de\ I1)$$

est mesurée par le composant de mesure 5.

Le microcontrôleur 6 estime ensuite les premières puissances électriques par les formules suivantes :

$$P_1 = \frac{2}{\sqrt{3}}.V2_{RMS}.\ I1_{RMS}.\cos\varphi 1$$

(première Puissance Active) ;

$$Q_1 = \frac{2}{\sqrt{3}}.VF2_{RMS}.\ IF1_{RMS}.\sin\varphi 1$$

(première Puissance Réactive) ;

$$S_1 = \frac{2}{\sqrt{3}}.V2_{RMS}.\ I1_{RMS}$$

(première Puissance Apparente).

Le facteur $\frac{2}{\sqrt{3}}$ permet de corriger l'impact de la fraude sur les amplitudes, qui a été évoqué plus tôt.

Avantageusement, lorsque le microcontrôleur 6 a détecté que le réseau de distribution 3 ne comprend pas de neutre en plus des trois phases (configuration à trois fils), et si la fraude ne fausse pas les deuxièmes mesures de tension, le microcontrôleur 6 corrige aussi au moins une deuxième puissance électrique consommée sur la deuxième phase Ph2. De même, si la fraude ne fausse pas les troisièmes mesures de tension, le microcontrôleur 6 corrige aussi au moins une troisième puissance électrique consommée sur la troisième phase Ph3.

La correction consiste à multiplier la au moins une deuxième puissance électrique et la au moins une troisième puissance électrique par un même facteur prédéterminé (correction d'amplitude), et à déphaser la au moins une deuxième puissance électrique d'un deuxième déphasage prédéfini, et la au moins une troisième puissance électrique d'un troisième déphasage prédéfini (correction de phase).

Le facteur prédéterminé est égal à $\frac{2}{\sqrt{3}}$ . Le deuxième déphasage prédéfini est égal à -30° et le troisième déphasage prédéfini est égal à +30°.

Le microcontrôleur 6 calcule donc :

$$P_2 = \frac{2}{\sqrt{3}}.V2_{RMS}.\ I2_{RMS}.\cos(\varphi 2 - 30°)$$

(deuxième Puissance Active) ;

$$Q_2 = \frac{2}{\sqrt{3}}.VF2_{RMS}.\ IF2_{RMS}.\sin(\varphi 2 - 30°)$$

(deuxième Puissance Réactive) ;

$$S_2 = \frac{2}{\sqrt{3}}.V2_{RMS}.\ I2_{RMS}$$

(deuxième Puissance Apparente) ;

$$P_3 = \frac{2}{\sqrt{3}}.V3_{RMS}.\ I3_{RMS}.\cos(\varphi 3 + 30°)$$

(troisième Puissance Active) ;

$$Q_3 = \frac{2}{\sqrt{3}}.VF3_{RMS} \, . \, IF3_{RMS}.\sin(\varphi3 + 30°)$$

(troisième Puissance Réactive) ;

$$S_3 = \frac{2}{\sqrt{3}}.V3_{RMS} \, . \, I3_{RMS}$$

(troisième Puissance Apparente).

La valeur :

$$\varphi3 = (Phase\ de\ V3 - Phase\ de\ I3)$$

est mesurée par le composant de mesure 5.

Comme on l'a vu, le microcontrôleur 6 doit détecter si la configuration est une configuration à quatre fils ou à trois fils, c'est-à-dire si le réseau de distribution 3 comprend ou non un neutre en plus des trois phases. L'estimation des premières puissances électrique diffère en effet selon la configuration effective. De même, l'application de la correction des deuxièmes puissances électriques et des troisièmes puissances électriques dépend de la configuration.

Le procédé d'estimation de puissance comprend donc une étape préliminaire consistant à détecter si le réseau 3 et le compteur 1 se trouvent dans une configuration à quatre fils ou à trois fils.

Pour cela, après avoir détecté une fraude sur la première phase Ph1, le microcontrôleur 6 mesure l'angle $\varphi$ entre les deux tensions restantes, c'est-à-dire entre la deuxième tension de phase V2 et la troisième tension de phase V3 (dans le cas où les deuxièmes mesures de tension de la deuxième tension de phase V2 et les troisièmes mesures de tension de la troisième tension de phase V3 ne sont pas faussées).

Le microcontrôleur 6 détermine alors si l'angle $\varphi$ est en valeur absolue proche de 180° et, si c'est le cas, détecte une configuration à trois fils.

Le microcontrôleur 6 vérifie si l'angle $\varphi$ appartient ou non à l'intervalle prédéfini :

$$180° - X° < |\varphi| < 180° + X°.$$

X est une valeur prédéfinie positive et inférieure à 30. On a par exemple X = 20.

Si l'angle $\varphi$ appartient à l'intervalle prédéfini, le microcontrôleur 6 considère que l'angle $\varphi$ est en valeur absolue proche de 180° et donc détecte une configuration à trois fils. Sinon, le microcontrôleur 6 détecte une configuration à quatre fils.

On note que, dans la configuration à trois fils, il est possible d'estimer les puissances qui auraient dû être consommées en l'absence de fraude seulement si une seule des entrées de tension est manquante (fraude sur une seule phase, car en 3 fils, si deux phases sont manquantes, le compteur n'est plus alimenté), alors que dans la configuration à quatre fils, il est possible de les estimer même dans le cas de deux entrées de tension manquantes.

On note aussi qu'il est possible que, dans le cas où le microcontrôleur 6 détecte que deux entrées de tension sont manquantes (fraude sur deux phases), le microcontrôleur 6 détecte systématiquement la configuration à quatre fils (puisque le compteur est alimenté) ; le compteur 1 met alors en oeuvre le procédé d'estimation dans les conditions correspondantes. En effet, les compteurs s'éteignent automatiquement lorsque la configuration est une configuration à trois fils et que deux tensions sont manquantes.

En variante, et quelle que soit la configuration (quatre fils ou trois fils), dans le cas où la fraude touche uniquement la première phase Ph1, il est possible, pour estimer les premières puissances électriques, d'acquérir au moins une deuxième mesure de tension, image d'une deuxième tension de phase V2 présente sur la deuxième phase Ph2, et au moins une troisième mesure de tension, image d'une troisième tension de phase V3 présente sur la troisième phase Ph3.

Le microcontrôleur 6 calcule alors une moyenne arithmétique de la au moins une deuxième mesure de tension et de la au moins une troisième mesure de tension pour estimer la au moins une première puissance électrique.

Ici, le microcontrôleur 6 calcule donc une moyenne arithmétique de $V2_{RMS}$ et de $V3_{RMS}$ pour estimer la première Puissance Active et la première Puissance Apparente, et de $VF2_{RMS}$ et de $VF3_{RMS}$ pour estimer la première Puissance Réactive.

Il est aussi possible d'utiliser un premier déphasage « moyen », obtenu en calculant une moyenne arithmétique d'un premier déphasage $\varphi$1 obtenu en utilisant des mesures sur la deuxième phase Ph2, et d'un premier déphasage $\varphi$1 obtenu en utilisant des mesures sur la troisième phase Ph3.

Les différentes étapes du procédé d'estimation sont visibles sur la figure 5.

Le procédé débute à l'étape E0.

Le microcontrôleur 6 tente de détecter au moins une fraude sur l'une des trois phases (étape E1).

Si aucune fraude n'est détectée, le microcontrôleur 6 acquiert les estimations de la Puissance Active, de la Puissance Réactive et de la Puissance Apparente calculées par le composant de mesure 5 pour les trois phases, et ne corrige pas ces estimations (étape E2). L'acquisition des puissances est réalisée à intervalles réguliers (cycle de 1s par exemple).

Le procédé retourne à l'étape E1.

A l'étape E1, si le microcontrôleur 6 détecte une fraude sur deux phases, le microcontrôleur 6 en déduit directement que la configuration est une configuration à quatre fils (voir ce qui vient d'être expliqué).

On suppose par exemple que les premières mesures de tension (de la première tension de phase V1) et les troisièmes mesures de tension (de la troisième tension de phase V3) sont faussées.

Le microcontrôleur 6 acquiert alors les mesures produites par le composant de mesure 5.

Le microcontrôleur 6 estime, pour la première phase Ph1, la première Puissance Active, la première Puissance Réactive et la première Puissance Apparente, à partir des mesures sur la deuxième phase Ph2 (qui elles ne sont pas faussées) : étape E3. La deuxième phase Ph2 est la phase de référence.

Puis, le microcontrôleur 6 estime, pour la troisième phase Ph3, la troisième Puissance Active, la troisième Puissance Réactive et la troisième Puissance Apparente, à partir des mêmes mesures sur la deuxième phase Ph2 (étape E4) .

Pour la deuxième phase Ph2, le microcontrôleur 6 acquiert les estimations de la deuxième Puissance Active, de la deuxième Puissance Réactive et la deuxième Puissance Apparente qui sont calculées par le composant de mesure 5, et ne corrige pas ces estimations (car la configuration est une configuration à 4 fils).

L'acquisition des puissances est réalisée à intervalles réguliers (cycle de 1s). Le procédé retourne à l'étape E1.

On suppose maintenant qu'à l'étape E1, le microcontrôleur 6 détecte une fraude sur une seule phase ; on suppose que les premières mesures de tension (première tension de phase V1) sont faussées.

Le microcontrôleur 6 détecte alors si le réseau 3 et le compteur 1 se trouvent dans une configuration à quatre fils ou à trois fils (étape E5).

Si la configuration à trois fils est détectée, le microcontrôleur 6 acquiert les mesures produites par le composant de mesure 5 et estime alors, pour la première phase Ph1, la première Puissance Active, la première Puissance Réactive et la première Puissance Apparente, à partir des mesures sur la deuxième phase Ph2 (qui ne sont pas faussées) : étape E6. La deuxième phase Ph2 est la deuxième phase de référence. Le microcontrôleur 6 aurait aussi pu utiliser les mesures sur la troisième phase Ph3.

De plus, le microcontrôleur 6 acquiert les estimations de puissance produites par le composant de mesure 5 pour la deuxième phase Ph2 et pour la troisième phase Ph3, et effectue alors une correction sur ces estimations de puissance (correction d'amplitude et correction de phase) : étape E7.

L'acquisition des puissances est réalisée à intervalles réguliers (cycle de 1s).

Le procédé repasse alors à l'étape E1.

A l'étape E5, si la configuration à quatre fils est détectée, le microcontrôleur 6 acquiert les mesures produites par le composant de mesure 5 et estime alors, pour la première phase Ph1, la première Puissance Active, la première Puissance Réactive et la première Puissance Apparente, à partir des mesures sur la deuxième phase Ph2 (qui ne sont pas faussées) : étape E8. La deuxième phase Ph2 est la phase de référence. Le microcontrôleur 6 aurait aussi pu utiliser les mesures sur la troisième phase Ph3.

Le microcontrôleur 6 acquiert les estimations de puissance produites par le composant de mesure pour la deuxième phase et pour la troisième phase et n'effectue pas de correction.

L'acquisition des puissances est réalisée à intervalles réguliers (cycle de 1s).

Le procédé repasse alors à l'étape E1.

Bien entendu, l'invention n'est pas limitée au mode de réalisation décrit mais englobe toute variante entrant dans le champ de l'invention telle que définie par les revendications.

On a indiqué que la première estimation de déphasage, permettant d'estimer la différence de phase entre la première tension de phase et la deuxième tension de phase, est égale à +120°. Bien sûr, cette valeur dépend des phases qui sont appelées « première phase » et « deuxième phase » ; la première estimation de déphasage pourrait être égale à - 120°.

De même, le deuxième déphasage prédéfini pourrait être égal à +30° et le troisième déphasage prédéfini à -30°.

**Revendications**

1. Procédé d'estimation de puissance, mis en oeuvre dans un compteur électrique triphasé (1) relié à trois phases d'un réseau de distribution (3), et comprenant les étapes de :

   - détecter une fraude faussant au moins une première mesure de tension, image d'une première tension de phase (V1) présente sur une première phase (Ph1) ;
   - acquérir au moins une deuxième mesure de tension, image d'une deuxième tension de phase (V2) présente sur une deuxième phase (Ph2), la au moins une deuxième mesure de tension n'étant pas faussée par la fraude ;

   **caractérisé en ce que**, le procédé comprend encore les étapes de:

   - estimer un premier déphasage entre la première tension de phase (V1) et un premier courant de phase (I1) circulant sur la première phase, en utilisant une première estimation de déphasage qui est une estimation théorique d'un déphasage attendu sans la fraude entre la première tension de phase (V1) et la deuxième tension de phase (V2) ;
   - estimer au moins une première puissance électrique consommée sur la première phase à partir d'au moins une première mesure de courant image du premier courant de phase, de la au moins une deuxième mesure de tension, et du premier déphasage.

2. Procédé d'estimation de puissance selon la revendication 1, dans lequel le premier déphasage est estimé à partir d'un déphasage entre la deuxième tension de phase (V2) et un deuxième courant de phase (I2) circulant sur la deuxième phase, d'une différence de phase entre le deuxième courant de phase (I2) et le premier courant de phase (I1), et de la première estimation de déphasage.

3. Procédé d'estimation de puissance selon l'une des revendications précédentes, dans lequel la première estimation de déphasage est égale à +120° ou à -120°.

4. Procédé d'estimation de puissance selon l'une des revendications précédentes, dans lequel la au moins une deuxième mesure de tension comprend une valeur efficace de la deuxième tension de phase (V2) et/ou un niveau sur une fréquence fondamentale de la deuxième tension de phase (V2).

5. Procédé d'estimation de puissance selon la revendication 4, dans lequel la au moins une première puissance électrique comprend une première Puissance Active estimée à partir de la valeur efficace de la deuxième tension de phase, d'une valeur efficace du premier courant de phase, et du premier déphasage, et/ou une première Puissance Réactive estimée à partir du niveau sur la fréquence fondamentale de la deuxième tension de phase, d'un niveau sur une fréquence fondamentale du premier courant de phase, et du premier déphasage, et/ou une première Puissance Apparente estimée à partir de la valeur efficace de la deuxième tension de phase et de la valeur efficace du premier courant de phase.

6. Procédé d'estimation de puissance selon l'une des revendications précédentes, dans lequel la fraude est détectée lorsque la au moins une première mesure de tension est inférieure à un seuil de tension prédéfini alors que la au moins une première mesure de courant est supérieure à un seuil de courant prédéfini.

7. Procédé d'estimation de puissance selon l'une des revendications précédentes, comprenant en outre les étapes, si la fraude fausse aussi au moins une troisième mesure de tension, image d'une troisième tension de phase (V3) présente sur une troisième phase (Ph3), d'utiliser à nouveau la au moins une deuxième mesure de tension pour estimer au moins une troisième puissance électrique consommée sur la troisième phase.

8. Procédé d'estimation de puissance selon l'une des revendications 1 à 6, comprenant en outre les étapes de :

   - acquérir au moins une troisième mesure de tension, image d'une troisième tension de phase (V3) présente sur une troisième phase (Ph3), la troisième mesure de tension n'étant pas faussée par la fraude ;
   - calculer une moyenne arithmétique de la au moins une deuxième mesure de tension et de la au moins une troisième mesure de tension pour estimer la au moins une première puissance électrique.

9. Procédé d'estimation de puissance selon la revendication 8, dans lequel le premier déphasage est obtenu en calculant une moyenne arithmétique d'un déphasage obtenu en utilisant des mesures sur la deuxième phase (Ph2) et d'un déphasage obtenu en utilisant des mesures sur la troisième phase (Ph3).

10. Procédé d'estimation de puissance selon l'une des revendications précédentes, comprenant en outre les étapes de détecter si le réseau de distribution (3) comprend ou non un neutre (N) en plus des trois phases et, si ce n'est pas le cas, de corriger au moins une deuxième puissance électrique consommée sur la deuxième phase (Ph2), et, si la fraude ne fausse pas au moins une troisième mesure de tension, image d'une troisième tension de phase présente sur une troisième phase, de corriger aussi au moins une troisième puissance électrique consommée sur la troisième phase (Ph3).

11. Procédé d'estimation de puissance selon la revendication 10, dans lequel la correction consiste à multiplier la au moins une deuxième puissance électrique et la au moins une troisième puissance électrique par un même facteur prédéterminé, et à déphaser la au moins une deuxième puissance électrique d'un deuxième déphasage prédéfini, et la au moins une troisième puissance électrique d'un troisième déphasage prédéfini.

12. Procédé d'estimation de puissance selon la revendication 11, dans lequel le facteur prédéterminé est égal à $\frac{2}{\sqrt{3}}$, et dans lequel le deuxième déphasage prédéfini est égal à -30° et le troisième déphasage prédéfini est égal à +30°.

13. Procédé d'estimation de puissance selon la revendication 11, dans lequel une absence de neutre (N) est détectée lorsqu'un angle φ entre la deuxième tension de phase (V2) et la troisième tension de phase (V3) est tel que :

$$180° - X° < |\varphi| < 180° + X°,$$

X étant une valeur prédéfinie positive et inférieure à 30.

14. Compteur électrique triphasé, comprenant un composant de traitement (6) agencé pour mettre en oeuvre le procédé d'estimation de puissance selon l'une des revendications précédentes.

15. Compteur électrique triphasé selon la revendication 14, comprenant en outre un composant de mesure (5), distinct du composant de traitement (6) et agencé pour produire la au moins une première mesure de tension, la au moins une deuxième mesure de tension et la au moins une première mesure de courant.

16. Programme d'ordinateur comprenant des instructions qui conduisent le composant de traitement (6) du compteur électrique triphasé (1) selon l'une des revendications 14 ou 15 à exécuter les étapes du procédé d'estimation de puissance selon l'une des revendications 1 à 13.

17. Support d'enregistrement lisible par ordinateur, sur lequel est enregistré le programme d'ordinateur selon la revendication 16.

**Patentansprüche**

1. Leistungsschätzungsverfahren, das in einem dreiphasigen Stromzähler (1) durchgeführt wird, der mit drei Phasen eines Verteilungsnetzes (3) verbunden ist, und die Schritte umfasst:

   - Detektieren eines Betrugs, der mindestens eine erste Spannungsmessung, Bild einer ersten Phasenspannung (V1), die auf einer ersten Phase (Ph1) vorhanden ist, verfälscht;
   - Erfassen mindestens einer zweiten Spannungsmessung, Bild einer zweiten Phasenspannung (V2), die auf einer zweiten Phase (Ph2) vorhanden ist, wobei die mindestens eine zweite Spannungsmessung durch den Betrug nicht verfälscht wird;

   **dadurch gekennzeichnet, dass** das Verfahren ferner die Schritte umfasst:

   - Schätzen einer ersten Phasenverschiebung zwischen der ersten Phasenspannung (V1) und einem ersten Phasenstrom (I1), der auf der ersten Phase fließt, indem eine erste Phasenverschiebungsschätzung verwendet wird, die eine theoretische Schätzung einer erwarteten Phasenverschiebung ohne den Betrug zwischen der ersten Phasenspannung (V1) und der zweiten Phasenspannung (V2) ist;

- Schätzen mindestens einer ersten elektrischen Leistung, die auf der ersten Phase verbraucht wird, anhand mindestens einer ersten Strommessung, Bild des ersten Phasenstroms, anhand der mindestens einen zweiten Spannungsmessung und der ersten Phasenverschiebung.

2. Leistungsschätzungsverfahren nach Anspruch 1, bei dem die erste Phasenverschiebung anhand einer Phasenverschiebung zwischen der zweiten Phasenspannung (V2) und einem zweiten Phasenstrom (12) geschätzt wird, der auf der zweiten Phase fließt, einer Phasendifferenz zwischen dem zweiten Phasenstrom (12) und dem ersten Phasenstrom (I1) und der ersten Phasenverschiebungsschätzung.

3. Leistungsschätzungsverfahren nach einem der vorhergehenden Ansprüche, bei dem die erste Phasenverschiebungsschätzung gleich +120° oder - 120° ist.

4. Leistungsschätzungsverfahren nach einem der vorhergehenden Ansprüche, bei dem die mindestens eine zweite Spannungsmessung einen Effektivwert der zweiten Phasenspannung (V2) und/oder einen Pegel auf einer Grundfrequenz der zweiten Phasenspannung (V2) umfasst.

5. Leistungsschätzungsverfahren nach Anspruch 4, bei dem die mindestens eine erste elektrische Leistung eine erste Wirkleistung umfasst, die anhand des Effektivwerts der zweiten Phasenspannung, eines Effektivwerts des ersten Phasenstroms und der ersten Phasenverschiebung geschätzt wird, und/oder eine erste Blindleistung umfasst, die anhand des Pegels auf der Grundfrequenz der zweiten Phasenspannung, eines Pegels auf einer Grundfrequenz des ersten Phasenstroms und der ersten Phasenverschiebung geschätzt wird, und/oder eine erste Scheinleistung umfasst, die anhand des Effektivwerts der zweiten Phasenspannung und des Effektivwerts des ersten Phasenstroms geschätzt wird.

6. Leistungsschätzungsverfahren nach einem der vorhergehenden Ansprüche, bei dem der Betrug erfasst wird, wenn die mindestens eine erste Spannungsmessung geringer als ein vordefinierter Spannungsschwellenwert ist, während die mindestens eine erste Strommessung höher als ein vordefinierter Stromschwellenwert ist.

7. Leistungsschätzungsverfahren nach einem der vorhergehenden Ansprüche, ferner umfassend die Schritte, wenn der Betrug auch mindestens eine dritte Spannungsmessung, Bild einer dritten Phasenspannung (V3), die auf einer dritten Phase (Ph3) vorhanden ist, verfälscht, des erneuten Verwendens der mindestens einen zweiten Spannungsmessung, um mindestens eine dritte elektrische Leistung zu schätzen, die auf der dritten Phase verbraucht wird.

8. Leistungsschätzungsverfahren nach einem der Ansprüche 1 bis 6, ferner umfassend die Schritte:

- Erfassen mindestens einer dritten Spannungsmessung, Bild einer dritten Phasenspannung (V3), die auf einer dritten Phase (Ph3) vorhanden ist, wobei die dritte Spannungsmessung durch den Betrug nicht verfälscht wird;
- Berechnen eines arithmetischen Mittels der mindestens einen zweiten Spannungsmessung und der mindestens einen dritten Spannungsmessung, um die mindestens eine erste elektrische Leistung zu schätzen.

9. Leistungsschätzungsverfahren nach Anspruch 8, bei dem die erste Phasenverschiebung ermittelt wird, indem ein arithmetisches Mittel einer Phasenverschiebung, die ermittelt wird, indem Messungen auf der zweiten Phase (Ph2) verwendet werden, und einer Phasenverschiebung berechnet wird, die ermittelt wird, indem Messungen auf der dritten Phase (Ph3) verwendet werden.

10. Leistungsschätzungsverfahren nach einem der vorhergehenden Ansprüche, ferner umfassend die Schritte des Detektierens, ob das Verteilungsnetz (3) einen Nullleiter (N) zusätzlich zu den drei Phasen umfasst oder nicht, und, wenn dies nicht der Fall ist, des Korrigierens mindestens einer zweiten elektrischen Leistung, die auf der zweiten Phase (Ph2) verbraucht wird, und, wenn der Betrug mindestens eine dritte Spannungsmessung, Bild einer dritten Phasenspannung, die auf einer dritten Phase vorhanden ist, nicht verfälscht, des Korrigierens ebenfalls mindestens einer dritten elektrischen Leistung, die auf der dritten Phase (Ph3) verbraucht wird.

11. Leistungsschätzungsverfahren nach Anspruch 10, bei dem die Korrektur darin besteht, die mindestens eine zweite elektrische Leistung und die mindestens eine dritte elektrische Leistung mit einem selben vorbestimmten Faktor zu multiplizieren, und die mindestens eine zweite elektrische Leistung um eine vordefinierte zweite Phasenverschiebung und die mindestens eine dritte elektrische Leistung um eine vordefinierte dritte Phasenverschiebung in Phase zu verschieben.

**12.** Leistungsschätzungsverfahren nach Anspruch 11, bei dem der vorbestimmte Faktor gleich $\frac{2}{\sqrt{3}}$ ist, und bei dem die vordefinierte zweite Phasenverschiebung gleich -30° und die dritte vordefinierte Phasenverschiebung gleich +30° ist.

**13.** Leistungsschätzungsverfahren nach Anspruch 11, bei dem ein Nichtvorhandensein des Nullleiters (N) erfasst wird, wenn ein Winkel φ zwischen der zweiten Phasenspannung (V2) und der dritten Phasenspannung (V3) derart ist, dass:

$$180° - X° < |φ| < 180° + X°,$$

wobei X ein positiver vordefinierter Wert und kleiner 30 ist.

**14.** Dreiphasiger Stromzähler, umfassend eine Verarbeitungskomponente (6), die ausgebildet ist, das Leistungsschätzungsverfahren nach einem der vorhergehenden Ansprüche durchzuführen.

**15.** Dreiphasiger Stromzähler nach Anspruch 14, ferner umfassend eine Messkomponente (5), die verschieden von der Verarbeitungskomponente (6) und ausgebildet ist, die mindestens eine erste Spannungsmessung, die mindestens eine zweite Spannungsmessung und die mindestens eine erste Strommessung durchzuführen.

**16.** Computerprogramm, umfassend Anweisungen, die die Verarbeitungskomponente (6) des dreiphasigen Stromzählers (1) nach einem der Ansprüche 14 oder 15 dazu veranlassen, die Schritte des Leistungsschätzungsverfahrens nach einem der Ansprüche 1 bis 13 auszuführen.

**17.** Computerlesbarer Aufzeichnungsträger, auf dem das Computerprogramm nach Anspruch 16 gespeichert ist.

**Claims**

**1.** Power estimation method, implemented in a three-phase electricity meter (1) connected to three phases of a distribution network (3), and comprising the steps of:

detecting a fraud falsifying at least one first voltage measurement, image of a first phase voltage (V1) present on a first phase (Ph1);
acquiring at least one second voltage measurement, image of a second phase voltage (V2) present on a second phase (Ph2), the at least one second voltage measurement not being falsified by the fraud; **characterized in that** the power estimation method further comprises the steps of:

estimating a first phase shift between the first phase voltage (V1) and a first phase current (I1) circulating on the first phase, by using a first phase shift estimation which is a theoretical estimation of an expected phase shift without the fraud between the first phase voltage (V1) and the second phase voltage (V2);
estimating at least one first electrical power consumed on the first phase from at least one first current measurement, image of the first phase current, from the at least one second voltage measurement, and from the first phase shift.

**2.** Power estimation method according to claim 1, wherein the first phase shift is estimated from a phase shift between the second phase voltage (V2) and a second phase current (I2) circulating on the second phase, of a phase difference between the second phase current (I2) and the first phase current (I1), and of the first phase shift estimation.

**3.** Power estimation method according to one of the preceding claims, wherein the first phase shift estimation is equal to +120° or to -120°.

**4.** Power estimation method according to one of the preceding claims, wherein the at least one second voltage measurement comprises an effective value of the second phase voltage (V2) and/or a level on a fundamental frequency of the second phase voltage (V2).

**5.** Power estimation method according to claim 4, wherein the at least one first electrical power comprises a first Active Power estimated from the effective value of the second phase voltage, from an effective value of the first phase current, and from the first phase shift, and/or a first Reactive Power estimated from the level on the fundamental frequency of the second phase voltage, from a level on a fundamental frequency of the first phase current, and from the first phase shift, and/or a first Apparent Power estimated from the effective value of the second phase voltage and from the effective value of the first phase current.

6. Power estimation method according to one of the preceding claims, wherein the fraud is detected when the at least one first voltage measurement is less than a predefined voltage threshold, while the at least one first current measurement is greater than a predefined current threshold.

7. Power estimation method according to one of the preceding claims, further comprising the steps, if the fraud also falsifies at least one third voltage measurement, image of a third phase voltage (V3) present on a third phase (Ph3), of again using the at least one second voltage measurement to estimate at least one third electrical power consumed on the third phase.

8. Power estimation method according to one of claims 1 to 6, further comprising the steps of:

   acquiring at least one third voltage measurement, image of a third phase voltage (V3) present on a third phase (Ph3), the third voltage measurement not being falsified by the fraud;
   calculating an arithmetic average of the at least one second voltage measurement and of the at least one third voltage measurement to estimate the at least one first electrical power.

9. Power estimation method according to claim 8, wherein the first phase shift is obtained by calculating an arithmetic average of a phase shift obtained by using measurements on the second phase (Ph2) and of a phase shift obtained by using measurements on the third phase (Ph3).

10. Power estimation method according to one of the preceding claims, further comprising the steps of detecting if the distribution network (3) comprises, or not, a neutral (N) in addition to the three phases and, if this is not the case, of correcting at least one second electrical power consumed on the second phase (Ph2), and, if the fraud does not falsify at least one third voltage measurement, image of a third phase voltage present on a third phase, of also correcting at least one third electrical power consumed on the third phase (Ph3).

11. Power estimation method according to claim 10, wherein the correction consists of multiplying the at least one second electrical power and the at least one third electrical power by one same predetermined factor, and of phase shifting the at least one second electrical power of a predefined second phase shift, and the at least one third electrical power of a predefined third phase shift.

12. Power estimation method according to claim 11, wherein the predetermined factor is equal to $\frac{2}{\sqrt{3}}$ , and wherein the predefined second phase shift is equal to -30° and the predefined third phase shift is equal to +30°.

13. Power estimation method according to claim 11, wherein an absence of neutral (N) is detected when an angle φ between the second phase voltage (V2) and the third phase voltage (V3) is such that:

$$180° - X° < |\varphi| < 180° + X°,$$

X being a positive predefined value and less than 30.

14. Three-phase electricity meter, comprising a processing component (6) arranged to implement the power estimation method according to one of the preceding claims.

15. Three-phase electricity meter according to claim 14, further comprising a measuring component (5), separate from the processing component (6) and arranged to produce the at least one first voltage measurement, the at least one second voltage measurement and the at least one first current measurement.

16. Computer program comprising instructions which drive the processing component (6) of the three-phase electricity meter (1) according to one of claims 14 or 15 to execute the steps of the power estimation method according to one of claims 1 to 13.

17. Recording media which can be read by a computer, on which the computer program is recorded, according to claim 16.

Fig. 1

Fig. 2

Fig. 3

Fig. 4

Fig. 5

E0 — ( Début )

E1 — Détection de fraude sur 1 ou 2 tensions ?

NON

Configuration à 4 fils

E2 — Prise en compte des calculs des puissances P, Q et S sur les 3 phases sans modification

1

2

E3 — Estimation des puissances P, Q et S de la 1ère phase manquante à partir de la phase de référence

E4 — Estimation des puissances P, Q et S de la 2ème phase manquante à partir de la phase de référence

E5 — Configuration à 3 fils ou 4 fils ?

3 fils

E6 — Estimation des puissances P, Q et S de la phase manquante à partir d'une des 2 phases de référence

E7 — Correction sur le calcul des puissances des 2 autres phases en amplitude et en déphasage

E8 — 4 fils — Estimation des puissances P, Q et S de la phase manquante à partir d'une des 2 phases de référence

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0455518 A2
- US 2013211751 A1
- US 6236197 B1
- US 2004150384 A1